# EUROPÄISCHE PATENTANMELDUNG

(11) **EP 4 518 084 A1**
(43) Veröffentlichungstag der Anmeldung: **05.03.2025**
(21) Anmeldenummer: 23194575.9
(22) Anmeldetag: 31.08.2023
(51) Int. Cl.: H02J 7/00, G01R 31/367

(54) **ZUSTANDSABHÄNGIGE HANDHABUNG EINER BATTERIE**

(71) Anmelder: Siemens Aktiengesellschaft, 80333 München (DE)
(72) Erfinder: Baldauf, Manfred, 91056 Erlangen (DE); Chakroun, Zied, 90491 Nürnberg (DE); Franke, Martin, 14089 Berlin (DE); Kumar, Avinash, 81379 München (DE); Pol, Sebastian, 90556 Seukendorf (DE); Schmid, Arthur, 80337 München (DE); Schulte, Sascha, 91315 Höchstadt (DE); Krubasik, Edward Cornelius, 80809 München (DE); Loskyll, Matthias, 92318 Neumarkt (DE); Taubensee, Sebastian, 04416 Markkleeberg (DE)
(74) Vertreter: Siemens Patent Attorneys

(57) **Zusammenfassung**

Die Erfindung betrifft ein Verfahren zur zustandsabhängigen Handhabung einer Batterie, mit einer Erfassung eines mittels eines Batteriemanagementsystems gespeicherten Betriebszustands-Datensatzes einer Batterie, mit einer computergestützte Verarbeitung des Betriebszustands-Datensatzes durch ein Expertensystem zur Erstellung einer Bewertung eines Zustands der Batterie, wobei die Bewertung in Abhängigkeit von einer Häufigkeit und/ oder Kombination von Betriebszuständen und einem Regelwerk erstellt wird, und mit einem Ausgeben der Bewertung des Zustandes zum Ableiten einer Handlungsempfehlung für eine Handhabung der Batterie, sowie eine zugehörige Steuerungseinheit und ein zugehöriges Computerprogramm.

## Beschreibung

Die Erfindung betrifft ein Verfahren zur zustandsabhängigen Handhabung einer Batterie mit einem Batteriemanagementsystem und einem Expertensystem sowie eine zugehörige Steuerungseinheit.

Batterien für den Gebrauch in Antriebssystemen in der Industrie und im Endanwenderumfeld nehmen weiterhin an Bedeutung zu. Entsprechend wächst auch die Bedeutung eines möglichst umfänglichen Recyclings von Batterien. Speicherbatterien für Elektrofahrzeuge und ähnliche Anwendungen werden nach Ablauf ihrer regulären Lebensdauer für ein Recycling geöffnet und zerlegt. Batterien aus dem Einsatz in Elektrofahrzeugen werden beispielsweise nach Ablauf ihrer regulären Lebensdauer entsorgt, recycelt oder in eine 2nd-life-Anwendung überführt.

Dazu werden die Batterien in entsprechenden Verwertungs-Einrichtungen zerlegt und verarbeitet. Eine der Bedingungen für eine sachgerechte Verarbeitung ist die Zustandsbestimmung der Batterien. Defekte Batterien oder solche, die bei der Zerlegung potenziell zu einer Gefahr werden könnten, dürfen nicht ohne erweiterte Schutzmaßahmen zerlegt werden. Ohne die Expertenaussage eines erfahrenen Technikers oder qualifizierte Prüfmaßnahmen ist es jedoch kaum möglich, den Sicherheitszustand einer Batterie zu ermitteln.

Herkömmlicherweise werden aufgrund noch geringer Recycling-Volumina Batterien weitgehend manuell zerlegt. Dabei werden diese individuell und durch Experten geprüft.

Es ist ferner denkbar, den Batteriezustand über das Batteriemanagementsystem, kurz BMS, abzufragen. Wenn dieses noch intakt ist und keine auffälligen Daten liefert, wird herkömmlicherweise angenommen, dass die Batterie keine signifikanten internen Defekte hat.

Vor diesem Hintergrund ist es eine Aufgabe der vorliegenden Erfindung eine Handhabung einer Batterie adaptiv und insbesondere sicher zu gestalten. Diese Aufgabe wird durch die Merkmale der unabhängigen Ansprüche gelöst. Vorteilhafte Ausgestaltungen sind in den abhängigen Ansprüchen angegeben.

Die Erfindung betrifft ein Verfahren zur zustandsabhängigen Handhabung einer Batterie, aufweisend folgende Schritte:
- Erfassung eines mittels eines Batteriemanagementsystems gespeicherten Betriebszustands-Datensatzes einer Batterie,
- computergestützte Verarbeitung des Betriebszustands-Datensatzes durch ein Expertensystem zur Erstellung einer Bewertung eines Zustands der Batterie, wobei die Bewertung in Abhängigkeit von einer Häufigkeit und/oder Kombination von Betriebszuständen und einem Regelwerk erstellt wird,
- Ausgeben der Bewertung des Zustandes zum Ableiten einer Handlungsempfehlung für eine Handhabung der Batterie.

Der Betriebszustandsdatensatz wird beispielsweis durch eine Steuerungseinheit, wie beispielsweise einen Industrie-PC mit PLC-Funktionalität, erfasst, sobald dieser mit dem Batteriemanagementsystem der Batterie verbunden ist und Zugriff hat. Beispielsweise sind die auf dem Batteriemanagementsystem gespeicherten Daten mittels kryptographischer Verfahren gesichert und es muss zunächst eine Authentifizierung der Steuerungseinheit erfolgen, bevor dieser Zugriff auf die Daten gegeben wird. Beispielsweise entschlüsselt die Steuerungseinheit die Daten mit einem ihr vorliegenden kryptographischen Schlüssel. Beispielsweise führt die Steuerungseinheit zu Zwecken der Authentifizierung eine kryptographische Funktion aus, um ihre Identität nachzuweisen und erhält dann die Daten in entschlüsselter Form.

Mit dem aus dem Batteriemanagementsystem abgerufenen Betriebszustandsdatensatz führt die Steuerungseinheit eine computergestützte Verarbeitung durch. Es wird ein Expertensystem herangezogen, das zur Erstellung einer Bewertung eines Zustands der Batterie genutzt wird. Aus den im Betrieb der Batterie im Batteriemanagementsystem aufgezeichneten Betriebsdaten leitet das Expertensystem bekannte Phänomene und Zustände ab.

Die Bewertung erfolgt anhand dessen, was aus einer Kombination aus über die Dauer des Betriebs der Batterie aufgezeichneten Betriebszuständen und/ oder einer Häufigkeit von über die Dauer des Betriebs der Batterie aufgezeichneten Betriebszuständen durch das Expertensystem mit Hilfe des Regelwerks ermittelbar ist: Im Regelwerk hinterlegte Muster, die durch diese Häufigkeiten und/oder Kombinationen gekennzeichnet sind, werden mit einer aktuelle vorgefundenen Information eines Batteriemanagementsystems abgeglichen und bei einer Übereinstimmung erfolgt eine Bewertung entsprechend einer dem erkanntnen Muster zugeordneten Bewertung. Das Expertensystem leitet aus den vorliegenden Daten beispielsweise eine individuelle "ok"- oder "Risiko von Fehlern/Gefahren"- Empfehlung ab. Diese Risikobewertung wird insbesondere mit einem quantifizierten Risikowert ergänzt, der angibt, mit welcher Wahrscheinlichkeit bei der im Regelwerk hinterlegten Häufigkeit und/ oder Kombination von Betriebszuständen eine bestimmte Bewertung sich auch als richtig erwiesen hat. In Weiterbildungen werden die Betriebszustandsdaten in ein Simulationsmodell überführt und dieses ermittelt dann die Risikobewertung und den vermuteten Sicherheits- oder Nutzwert.

Das Regelwerk bildet Informationen über den Einfluss der Häufigkeit von Betriebszuständen, die eine Batterie während ihrer Lebensdauer eingenommen hat, und der Kombinationen von verschiedenen Betriebszuständen, die hintereinander eingenommen wurden, auf die Eintrittswahrscheinlichkeit von Gefährdungen ab. Ein computerimplementierter Mechanismus vergleicht den aus dem Batteriemanagementsystem ausgelesenen Betriebszustands-Datensatzes mit den gespeicherten Informationen und leitet Gefährdungseinstufungen ab. Beispielsweise erfolgt anschließend ein Ermitteln und Ausgeben einer Empfehlung zur Vorgehensweise beim Zerlegen der Batterie ebenfalls auf der Steuerungseinheit.

Das Verfahren erlaubt es, in einem automatisierten Prozess potenziell gefährliche Batterien zu identifizieren, ohne dabei menschlichen Experten oder eine manuelle Inspektion zu benötigen. Das Verfahren beruht vorteilhafterweise nicht nur auf den im Batteriemanagementsystem gespeicherten einzelnen Zuständen, also quasi einzelnen Momentaufnahmen des Zustands der Batterie im Betrieb, sondern betrachtet eine Historie der im Batteriemanagementsystem gespeicherten Zustände, nämlich die Häufigkeit und/ oder Kombination von Zuständen. Dies ermöglicht eine Erkennung von Risiko-behafteten Batterien, obwohl einzelne Zustände noch keine Fehlermeldung o.ä. im Batteriemanagementsystem verursacht haben oder verursachen würden. Zudem ist es auf vorteilhafte Weise unnötig, bei der Gefahreneinschätzung auf einen Menschen und dessen Fehleranfälligkeit vertrauen zu müssen, die aufgrund der Vielzahl der Daten, die im Batteriemanagementsystem aufgezeichnet werden, nicht zu vernachlässigen ist.

Gemäß einer Ausgestaltung ist das Regelwerk statisch hinterlegt. Das Regelwerk umfasst statisch alle Regeln, nach denen die Bewertung der Batterie in Hinblick auf eine weitere Handhabung, insbesondere Verwendung zu Verwertungszwecken wie Reparatur, Wiederverwendund, Zerlegung, Recycling usw. erfolgt. Das Regelwerk basiert auf Erfahrungswerten und Expertenwissen und wird über die Beobachtung einer Vielzahl von Zerlegungsprozessen aufgebaut.

Gemäß einer Ausgestaltung wird das Regelwerk regelmäßig aktualisiert oder erweitert. Beispielsweise werden neue Batterietypen in das Regelwerk aufgenommen oder es werden angepasste Bewertungen hinterlegt, die aufgrund andauernder Beobachtung erfolgter Handhabungsprozesse, insbesondere erfolgter Zerlegungen von Batterien, die auf Grundlage der erfindungsgemäßen Bewertung erfolgen, als Feedback an das Expertensystem übergeben werden. Das Regelwerk wird insbesondere regelmäßig über einen remote-update-service um neue Phänomene oder eine detailliertere Beschreibung bekannter Zustände erweitert.

Gemäß einer Ausgestaltung wird die Häufigkeit von während einer Betriebszeit erfolgten Schützoperationen für die Bewertung berücksichtigt. Beispielsweise stellen klemmende oder klebende Hauptschütze ein Risiko dar: bei sehr hoher Anzahl von Schütz-Operationen steigt das Risiko einer mechanischen Verklemmung. Wenn also beispielsweise die Anzahl der im Batteriemanagementsystem mitgezählten Schützoperationen einen gewissen Grenzwert übersteigt, wird die Batterie als "potenziell anfällig für Schaltfehler" eingestuft und beispielsweise als für die Wiederverwendung ungeeignet eingestuft. Insbesondere werden zusätzliche Informationen für die Bewertung herangezogen, wie beisielsweise hohe Stromstärken bei den Schützoperationen, die den Effekt verstärken.

Beispielsweise werden auch vorgeschädigte Hauptschütze aus dem Auslesen der Daten des Batteriemanagementsystems erkannt, die bei einer ungünstigen Kombination neuer Steuerbefehle zum Klemmen führen können und eine dauerhaft unter Hochspannung stehende Batterie bewirken können.

Gemäß einer Ausgestaltung wird die Kombination von während einer Betriebszeit eingenommenen Temperaturen, Ladezuständen und/oder Überströmen für die Bewertung berücksichtigt. Beispielsweise wird eine Kombination aus Temperaturen, Ladezuständen und zurückliegenden Überströmen als ungünstig erkannt. Hat eine Batterie in der Vergangenheit häufiger als empfohlen einen zu hohen Strom eingeprägt bekommen, kann sie ein stark erhöhtes, latentes Risiko eines internen Kurzschlusses in sich tragen.

Beispielsweise kommt es bei zu höhen Ladeströmen bei geringer Temperatur zu einem "Plating". Bei hohen Strömen bei hoher Temperatur kann es intern zu Hotspots mit Beschädigung der Struktur kommen. Bei hohen Temperaturen in großer Häufigkeit kommt es beispielsweise vermehrt zur Elektrolyttrocknung, also einer beschleunigten Alterung.

Die Kombinations-Effekte sind unterschiedlich kritisch, wobei einige auf die Alterung wirken, andere auf das Gefahrenpotenzial.

Wenn darüber hinaus auch noch eine Über- oder Tiefentladung vorliegt, könnte dieses Risiko typspezifisch noch einmal erhöt sein.

Gemäß einer Ausgestaltung wird eine Häufigkeit von während einer Betriebszeit erfolgten Über- oder Tiefentladungen für die Bewertung berücksichtigt. So könnte beispielsweise eine Batterie tiefentladen oder ggf. sogar negativ über-entladen worden sein, so dass ein erhöhtes Risiko besteht, dass die Zellen bei einer versehentlichen erneuten Benutzung in Brand geraten. Dies wird durch eine entsprechend deutliche Risiko-Beurteilung und insbesondere Gefährdungskennzeichnung bei der Ausgabe der Bewertung berücksichtigt. Bei negativer Entladung mit Polaritätswechsel oder bei Unterschreiten einer Mindestspannung >0 V gilt die Batterie insbesondere als defekt. Zersetzungsvorgänge, die im Inneren begonnen haben, sind dann mit einem hohen Sicherheitsrisiko bei weiterer Verwendung verbunden. Bei leichteren Über- oder Tiefentladungen wird die Kombination aus Häufigkeit und Schwere von einem Modell bewertet.

Gemäß einer Ausgestaltung ist das Regelwerk herstellerspezifisch oder Batterietyp-spezifisch. Batterien sind insbesondere verschieden robust oder verschieben unempfindlich gegenüber extremen Beanspruchungen wie Tiefentladung oder Temperaturereignissen, beispielsweise Brand im Umfeld der Batterie o.ä. Dies kann durch das Expertensystem berücksichtigt werden, indem beispielsweise bei gleicher Logik unterschiedliche Grenzwerte je nach Batterietyp oder -Hersteller hinterlegt sind.

Gemäß einer Ausgestaltung wird ein machine-learning-basiertes Verfahren basierend auf überwachtem Lernen eingesetzt und eine weitere Bewertung des Zustands der Batterie erstellt. Die Erkennung von Risiken oder Auffälligkeiten mittels des Regelwerk-basierten Expertensystems kann mittels maschinellen Lernens verstärkt werden.

Dafür wird ein machine-learning System mit gelabelten Daten angelernt. In einer Trainingsphase werden dafür dem machine-learning System Trainings-Daten, die Häufigkeiten und/ oder Kombinationen von Betriebszuständen beschreiben sowie eine diesen Charakteristika entsprechende in der Realität als korrekt erprobte Bewertung als sogenannte ground truth Daten übergeben und das System an diesen Daten trainiert. Die Daten sind mit Labels wie "gefährlich" bzw. "ungefährlich" oder "nicht wiederverwendbar" bzw. "wiederverwendbar" oder "nicht aufbereitbar" oder "aufbereitbar" etc. versehen. Dabei wird ein kritisches Label, also "gefährlich" oder "nicht wiederverwendbar" oder "nicht aufbereitbar" dann vergeben, wenn eine der Batterien bei oder nach der Zerlegung einen unerwünschten Zustand bis hin zu Bränden eingenommen hat. Dieses Ereignis wird dem lernenden System mitgeteilt und mit dem vorher ermittelten Foto/Scan verknüpft, so dass das selbstlernende System im Laufe der Zeit eine gut/schlecht Basis hat. Beispielsweise wird so ein machine-learning basiertes Verfahren umfassend trainiert, welches dann im realen Betrieb in einem der obigen Verfahren eingesetzt wird.

Insbesondere ist der Mechanismus auf der Steuerungseinheit selbstlernend und die Informationen über den Einfluss der Betriebszustände auf die Häufigkeit von Gefährdungen werden aus Erkenntnissen beim späteren Zerlegen abgeleitet. Insbesondere müssen die Erfahrungen oder physikalischen Zusammenhänge nicht oder für einen aktuelle Batterietyp dann nicht vorliegen.

Beispielsweise werden nach einer entsprechenden Anlernzeit auch Auffälligkeiten erkannt, die keine direkte physikalische Erklärung wie beispielsweise die gut dokumentierten Isolationsschäden haben oder ohne dass ein Fehlerpotenzial physikalisch erklärt werden kann. Solche Effekte werden beispielsweise erst durch eine große Anzahl untersuchter Batterien und entsprechend klassifizierter Datensätze, die als Trainingsdaten für das Trainieren des machine-learning basierten Verfahrens verwendet werden, durch den Betrieb des machine-learning basierten Verfahrens selbst erkannt.

Beispielsweise wird dazu das Risiko über Lernroutinen ermittelt. Zu jedem Batteriespeicherinhalt wird der Zustand aller einzelnen Parameter, insbesondere der State of Charge, SoC, der State of Health, SoH, etc. ausgelesen und abgespeichert. Wenn im Laufe der Zeit unerwünschter Weise einzelne Batterien während der Zerlegung Defekte aufweisen oder in gefährliche Zustände wechseln, können diese Ereignisse dem bereits gespeicherten Datensatz zugeordnet werden. Nach einer gewissen Zeit kann dann bei erneutem Auftreten des spezifischen Datenmusters eine Warnung ermittelt werden. Diese lernende Bewertung profitiert dabei besonders von Fuzzy-Methoden, bei denen auch nur "ungefähr ähnliche" Zustände in die Bewertung aufgenommen werden.

Es findet vorzugsweise ein kontinuierlich mitlernendes AI-Verfahren Anwendung, das die Daten aus dem laufenden Betrieb wiederum als Trainingsdaten verwendet. Beispielsweise wird ein neu-Lernen in einem vorgegebenen zeitlichen Abstand durchgeführt.

Das Verfahren erkennt dann Fälle, die einerseits nicht dem "ungefährlich"-Zustand aus der Trainingsphase zuzuordnen sind, die aber auch nicht den "gefährlich" gelabelten Daten entsprechen. Das aus der Trainingsphase angelernte Verfahren ist somit zu einer Mustererkennung für unbekannte Muster in den aufgezeichneten Daten des Batteriemanagementsystems im laufenden Betrieb fähig.

Somit erfolgt ein Training von Basisdaten auf Basis vieler vorheriger Messungen sowie sogenannten "ground truth"-Daten von Batterie-Komponenten im Neuzustand. Das Training verfeinert die Akzeptanzgrenzen, innerhalb welcher die Entscheidung des AI-Systems für eine bestimmte Bewertung erfolgt.

Gemäß einer Ausgestaltung erfolgt das machine-learning-basierte Verfahren unter Ausnutzung von Fuzzy-Logik-Methoden. So kann die lernende Beurteilung auch nur "ungefähr ähnliche" Zustände in die Bewertung aufnehmen.

Gemäß einer Ausgestaltung erfolgt das machine-learning-basierte Verfahren zusätzlich, insbesondere parallel oder nachgeschaltet, zur Erstellung der Bewertung des Zustands der Batterie durch das Expertensystem und es erfolgt ein Ausgeben der Bewertung sowie der weiteren Bewertung des Zustands zum Ableiten der Handlungsempfehlung.

Somit wird vorzugsweise das schnelle, berührungslose Verfahren basierend auf der Bewertung durch das Expertensystem genutzt. Die Bewertung wird anhand des Betriebszustands-Datensatzes auf dem vorgesehenen Weg bereitgestellt, vorzugsweise über HMI Geräte einer Steuerungseinheit oder einer Steuerung der Anlage, die für ein Batterie-Recycling genutzt wird. Zugleich wird das AI-System eingesetzt. Dies wird zeitlich parallel oder nachgeschaltet durchgeführt.

Dieses ermöglicht feinere Analysen und identifiziert insbesondere "false-positives", also irrtümlicherweise durch das Expertensystem auf Basis des Regelwerks als gefährlich eingestufte Batterien, und kennzeichnet diese für ein für die unkritischen Batterien geeignetes Recycling-Verfahren.

Ferner werden durch die AI-gestützten Analysen Muster in den Betriebszustands-Datensätzen erkannt, die nur aufgrund großer zu analysierender Datenmengen erkannt werden und bei Einsatz eines Bewertungssystems auf Basis des Regelwerks unerkannt blieben, da sie noch unbekannt sind und deshalb noch nicht in das Regelwerk eingegangen sind, oder da sie mit großen Varianzen auftreten, weil beispielsweise die Auswirkungen von Kombinationen an State of Health Daten und State of Charge Daten oder der Häufigkeit von Temperatur-Extremen von weiteren äußeren Faktoren abhängen, die eine Mustererkennung durch Experten, welche dem Regelwerk zugrunde liegen, erschweren.

Vorteilhafterweise ist die Analyse mittels der machine-learning basierten Verfahrens robust gegenüber geringen Schwankungen hinsichtlich der exakten Häufigkeit aufgetretener Ereignisse oder der Kombination von Ereignissen in der Historie des Batterie-Betriebszustands, was insbesondere durch Fuzzy-Mechanismen realisiert wird.

Es wird somit zusätzlich die Bewertung anhand des AI-Verfahrens ermittelt und ausgegeben. Eine erweiterte Handlungsempfehlung berücksichtigt beide Bewertungen und gibt insgesamt die am wenigsten einschränkende zugleich noch als sicher eingestufte Empfehlung für eine weitere Handhabung der Batterie aus.

In Varianten wird auch die Handlungsempfehlung rein auf Basis des Expertensystems mit dem Regelwerk ausgegeben, insbesondere um zu Zwecken der Dokumentation und Weiterentwicklung des Systems beide Bewertungen im Vergleich abzulegen. So wird beispielsweise Handlungsbedarf besonders leicht ersichtlich, wenn die AI-Bewertung zu oft von der Expertensystem-basierten Bewertung abweicht.

Die Erfindung betrifft ferner eine Steuerungseinheit zur zustandsabhängigen Handhabung einer Batterie mit einem Batteriemanagementsystem und einem Prozessor, ausgestaltet zum Ausführen des Verfahrens nach einem der vorstehend beschriebenen Ausgestaltungen.

Die Erfindung betrifft ferner ein Computerprogramm umfassend Befehle, die bei der Ausführung des Programms durch einen Computer diesen veranlassen, das Verfahren nach einem der vorstehend beschriebenen Ausgestaltungen auszuführen.

Die Erfindung wird nachfolgend anhand von Ausführungsbeispielen mit Hilfe der Figuren näher erläutert. Es zeigen:
- FIG 1: eine schematische Darstellung einer Steuerungseinheit zur zustandsabhängigen Handhabung einer Batterie gemäß einem ersten Ausführungsbeispiel der Erfindung;
- FIG 2: eine schematische Darstellung eines Diagramms zur Veranschaulichung eines Verfahrens zur zustandsabhängigen Handhabung einer Batterie gemäß einem zweiten Ausführungsbeispiel der Erfindung.

In den Figuren sind funktionsgleiche Elemente mit denselben Bezugszeichen versehen, sofern nichts anderes angegeben ist.

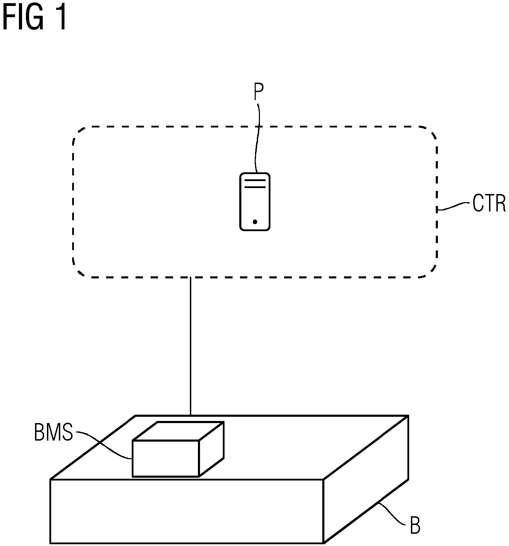

In FIG 1 ist eine Steuerungseinheit CTR gezeigt, die einen Prozessor P aufweist und welche in einer Recyclinganlage für Batterien, insbesondere in einer automatisierten Verarbeitungszelle mit entsprechendem Logistik- und Handling-Equipment, insbesondere AGVs und Robotergreifarmen, vorgesehen ist, um eine eintreffende Batterie B zu analysieren.

Die Steuerungseinheit CTR wird mit der Batterie B verbunden, um aus dem Batteriemanagementsystem BMS aus einem Speicher einen Betriebszustands-Datensatzes 10 auszulesen. Je nach eintreffendem Batterietyp wird ein Zugriffsverfahren für die Daten im Batteriemanagementsystem durchgeführt.

Beispielsweise ist eine an die Batterie B angepasste Applikationssoftware auf dem Batteriemanagementsystem BMS vorgesehen, die eine Basis-Software einer Prozessoreinheit des Batteriemanagementsystems BMS ergänzt. Insbesondere wird das Batteriemanagementsystem BMS so an das Einsatzgebiet der Batterie B angepasst. Beispielsweis erfolgt eine Anpassung, wie viele Temperatursensoren für einen Batterietyp für den Einsatz in einem bestimmten Fahrzeug im Batteriemanagementsystem BMS abbildbar sein sollen.

Beispielsweise werden auch Anpassungen für ein kryptographisches Verfahren zur Identifikation der Steuerungseinheit CTR bei dem Batteriemanagementsystem BMS auf diese Weise angepasst an ein Einsatzgebiet. Beispielsweise wird dabei kryptographisches Schlüsselmaterial des Batterieherstellers auf dem Batteriemanagementsystem BMS hinterlegt, so dass ein Zugriff auf die gespeicherten Daten für bestimmte Steuerungseinheiten bestimmter Hersteller möglich ist. So soll sichergestellt werden, dass die Daten nur für die vorgesehenen Recycling-Zwecke ausgelesen werden können.

Beispielsweise verfügt die Steuerungseinheit über ein HMI, über das die Ausgabe der Bewertung des Zustands der Batterie B erfolgt. Beispielsweise bringt dieses HMI zugleich Informationen zu den auf dem Batteriemanagementsystem gespeicherten Rohdaten zur Anzeige, insbesondere die Rohdaten selbst sowie Metadaten zu Aufzeichnungszeitpunkten etc.

Beispielsweise umfasst der Prozessor P der Steuerungseinheit CTR weitere Funktionalitäten und ist je nach weiterer Ausgestaltung einer Recyclinganlage ausgebildet. In einfachen Ausführungen ist auf der Steuerungseinheit CTR ein Warnsystem realisiert, das über Ampelfarben an einer Leuchte innerhalb der Automatisierungszelle das Vorliegen einer Bewertung der Batterie als potentiell gefährlich oder das Vorliegen einer abgeleiteten Handlungsempfehlung anzeigt, die eine anschließende Weiterverarbeitung der Batterie unter besonderen Sicherheitsmaßnahmen empfiehlt.

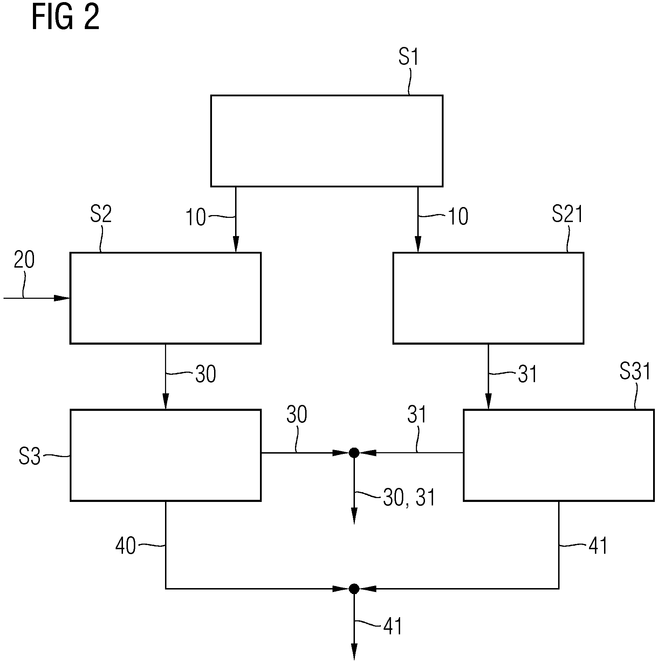

FIG 2 veranschaulicht anhand eines Ablaufdiagramms ein Verfahren zur zustandsabhängigen Handhabung einer Batterie gemäß einem zweiten Ausführungsbeispiel. In einem ersten Schritt erfolgt eine Erfassung S1 eines mittels eines Batteriemanagementsystems BMS gespeicherten Betriebszustands-Datensatzes 10 einer Batterie.

Dieser Betriebszustands-Datensatz 10 wird durch ein Expertensystem einer computergestützten Verarbeitung S2 unterzogen zur Erstellung einer Bewertung 30 eines Zustands der Batterie. Als Ergebnis wird eine Bewertung 30 des Zustands der Batterie B ausgegeben. Es erfolgt das Ausgeben S3 der Bewertung 30, beispielsweise zu Zwecken der Informationswiedergabe über eine Steuerungseinheit einer Batterie-Recyclinganlage, die zugleich für das Auslesen des Batteriemanagementsystems zuständig ist. Die Bewertung 30 wird in Abhängigkeit von einer Häufigkeit und Kombination von Betriebszuständen und einem Regelwerk 20 erstellt.

Der Betriebszustands-Datensatz 10 wird zudem auch einem machine-learning-basierten Programm übergeben, das zusätzlich eingesetzt wird S21, um aufgrund der Informationen aus dem Batteriemanagementsystem Aussagen über das Gefährdungspotential sowie die Tauglichkeit der Batterie zur weiteren Verwendung zu treffen. Es wird eine weitere Bewertung 31 der AIbasierten Analyse erstellt und ausgegeben S31.

Somit liegen für eine zu bewertende Batterie beide Analyseergebnisse, also beide Bewertungen 30, 31 vor.

Angelernt wurde das AI-System mit Trainingsdaten aus manuellen Analysen von Batterien von Experten oder vorzugsweise aus Analysen wie dem oben beschriebenen, das bereits die Regelwerk-basierte Analyse durch das Expertensystem durchführt, ergänzt um quasi eine Validierung aus dem Betrieb, also beispielsweise einer Korrektur in Fällen, in welchen die Bewertung 30 durch das Expertensystem eine Beschädigung der Batterie angezeigt hat, diese jedoch intakt war, oder anders herum.

Nach einer Training-Phase kann dann bei erneutem Auftreten eines spezifischen Datenmusters eine Warnung ermittelt werden. Beispielsweise ergibt sich, dass von 10.000 insgesamt analysierten Batterien eines bestimmten Typs 20 das gleiche Datenmuster im Batteriemanagementsystem gespeichert haben. Von diesen sind 8 später in einen kritischen Zustand gewechselt, daher besteht eine 40%-Wahrscheinlichkeit einer Gefahr. Diese lernende Bewertung profitiert dabei besonders von Fuzzy-Methoden, bei denen auch nur "ungefähr ähnliche" Zustände in die Bewertung aufgenommen werden.

Es wird gemäß dem zweiten Ausführungsbeispiel der Erfindung nur die abgeleitete erweiterte Handlungsempfehlung 41 des AIbasierten Verfahrens ausgegeben. Diese wird zugleich für die weitere Handhabung und Verarbeitung der Batterie in der Anlage genutzt.

In Kombination mit einem Regelwerk, das zu jedem individuellen Datensatz aus dem Batteriemanagementsystem mittels des Machine-Learning Verfahrens laufend Aktualisierungen für die Bewertung festhält, kann für jede geöffnete Batterie eine Empfehlung bzgl. ihres Gefahrpotenzials ausgesprochen werden.

Für Recycling-Anwendungen ist insbesondere die Abgrenzung von Interesse, ob die Batterie in Teilen für ein Ersatzteillager geeignet ist oder ob eine Wiederverwendung, auch für Teile, ausgeschlossen ist.

Viele der Informationen, die für diese Einschätzung relevant sind, sind einer Batterie weder äußerlich noch nach einem Öffnen innerlich anzusehen. Das Batteriemanagementsystem gibt zahlreiche Hinweise. Beispielsweise werden Neigungswinkelsensoren eingesetzt oder Temperaturbiegestreifen, die eine Historie des Einsatzes der Batterie belegen und insbesondere über Unfälle von Fahrzeugen, in welche die Batterie verbaut wurde, Auskunft geben. Ferner sind beispielsweise Nanopartikel vorgesehen, die erst bei einer spezifischen Feuchtigkeit, Spannung oder Temperatur eine Veränderung durchlaufen oder nachweisbar sind und dadurch eine Aufzeichnung von Umgebungsbedingungen realisieren. Auch diese Angaben werden vorteilhafterweise über das Batteriemanagementsystem abfragbar gespeichert.

Der Inhalt der Aufzeichnungen im Batteriemanagementsystem gibt insbesondere Auskunft über eine nicht-Eignung für eine weitere Verwendung, auch wenn im Betrieb der Batterie diese keinen Fehlerzustand ausgelöst hat oder hätte.

## Patentansprüche

1. Computerimplementiertes Verfahren zur zustandsabhängigen Handhabung einer Batterie (B), aufweisend folgende Schritte:
- Erfassung (S1) eines mittels eines Batteriemanagementsystems (BMS) gespeicherten Betriebszustands-Datensatzes (10) einer Batterie (B),
- computergestützte Verarbeitung (S2) des Betriebszustands-Datensatzes (10) durch ein Expertensystem (E) zur Erstellung einer Bewertung (30) eines Zustands der Batterie (B), wobei die Bewertung (30) in Abhängigkeit von einer Häufigkeit und/ oder Kombination von Betriebszuständen und einem Regelwerk (20) erstellt wird,
- Ausgeben (S3) der Bewertung (30) des Zustandes zum Ableiten einer Handlungsempfehlung (40) für eine Handhabung der Batterie (B).

2. Verfahren nach Anspruch 1, wobei das Regelwerk (20) statisch hinterlegt ist.

3. Verfahren nach Anspruch 1 oder 2, wobei das Regelwerk (20) regelmäßig aktualisiert oder erweitert wird.

4. Verfahren nach einem der vorstehenden Ansprüche, wobei die Häufigkeit von während einer Betriebszeit erfolgten Schützoperationen für die Bewertung (30) berücksichtigt wird.

5. Verfahren nach einem der vorstehenden Ansprüche, wobei die Kombination von während einer Betriebszeit eingenommenen Temperaturen, Ladezuständen und/ oder Überströmen für die Bewertung (30) berücksichtigt wird.

6. Verfahren nach einem der vorstehenden Ansprüche, wobei eine Häufigkeit von während einer Betriebszeit erfolgten Über- oder Tiefentladungen für die Bewertung (30) berücksichtigt wird.

7. Verfahren nach einem der vorstehenden Ansprüche, wobei das Regelwerk (20) herstellerspezifisch oder Batterietyp-spezifisch ist.

8. Verfahren nach einem der vorstehenden Ansprüche, wobei ein machine-learning-basiertes Verfahren basierend auf überwachtem Lernen eingesetzt wird (S21) und eine weitere Bewertung (31) des Zustands der Batterie (B) erstellt wird.

9. Verfahren nach einem der vorstehenden Ansprüche, wobei das machine-learning-basierte Verfahren unter Ausnutzung von Fuzzy-Logik-Methoden erfolgt.

10. Verfahren nach einem der vorstehenden Ansprüche, wobei das machine-learning-basierte Verfahren zusätzlich, insbesondere parallel oder nachgeschaltet, zur Erstellung der Bewertung (30) des Zustands der Batterie (B) durch das Expertensystem (E) erfolgt und ein Ausgeben (S3, S31) der Bewertung (30) sowie der weiteren Bewertung (31) des Zustands zum Ableiten einer erweiterten Handlungsempfehlung (41) erfolgt.

11. Steuerungseinheit (CTR) zur zustandsabhängigen Handhabung einer Batterie (B) mit einem Batteriemanagementsystem (BMS) und einem Prozessor (P), ausgestaltet zum Ausführen des Verfahrens nach einem der vorstehenden Ansprüche.

12. Computerprogramm umfassend Befehle, die bei der Ausführung des Programms durch einen Computer diesen veranlassen, das Verfahren nach einem der Ansprüche 1-10 auszuführen.
